# EUROPEAN PATENT APPLICATION

(11) **EP 1 298 442 A1**
(43) Date of publication of application: **02.04.2003**
(21) Application number: 02021223.9
(22) Date of filing: 18.09.2002
(51) Int. Cl.: G01P 15/08, G01P 15/00, G01P 15/12

(54) **Acceleration sensor**

(30) Priority: 26.09.2001 JP 2001293526; 28.11.2001 JP 2001363371
(71) Applicant: HITACHI METALS, LTD., Minato-ku, Tokyo (JP)
(72) Inventor: Saitoh, Matakatsu, Yokohama (JP); Tanaka, Shigenori, Mohka (JP); Ikeda, Yoshio, Oyama (JP)
(74) Representative: Beetz & Partner Patentanwälte

(57) **Abstract**

The invention relates to a microminiature and thin semiconductor acceleration sensor with high sensitivity is provided. The acceleration sensor has a mass portion (2) formed in a center part of a silicon semiconductor substrate, a frame (1) formed at a perimeter portion of the substrate, thin elastic support arms (3), which are provided at upper part of the mass portion (2) and the frame (1) and connect the mass portion (2) and the frame (1), and a plurality of pairs of piezoresistors disposed on top surface sides of the elastic support arms (3). In the mass portion (2), a plurality of recessed portions (51) which are recessed toward a center thereof from a perimeter thereof are formed, each of the elastic support arms (3) is attached to the top surface of the mass portion (2) at the bottom of each of the recessed portions (51), and sides of the elastic support arms (3) are spaced from sides of the recessed portions (51). Since the volume of the mass portion (2) and the length of the elastic support arms (3) can be independently made large, sensitivity can be made higher. The resulting mass portion has a clover shape.

## Description

### BACKGROUND OF THE INVENTION

### 1. Field of the Invention

The present invention relates to an acceleration sensor for detecting acceleration, which is used for toys, automobiles, aircrafts, portable terminals and the like, and particularly to an acceleration sensor that can be produced using a semiconductor technology.

### 2. Description of the Related Art

Acceleration sensors utilizing a change in physical quantity such as a piezo resistance effect and a change in electrostatic capacity have been developed and commercialized. These acceleration sensors can be widely used in various fields, but recently, such small-sized acceleration sensors as can detect the acceleration in multi-axial directions at one time with high sensitivity are demanded.

Since silicon single crystal becomes an ideal elastic body due to the extreme paucity of lattice defect and since a semiconductor process technology can be applied for it without large modification, much attention is paid to a piezo resistance effect type semiconductor acceleration sensor in which a thin elastic support portion is provided at a silicon single crystal substrate, and the stress applied to the thin elastic support portion is converted into an electric signal by a strain gauge, for example, a piezo resistance effect element, to be an output.

As a conventional triaxial acceleration sensor, there is the one disclosed in, for example, Japanese Laid-Open Patent No. 63-169078, and its plan view is shown in FIG. 15, and a sectional view taken along the XVI-XVI line in FIG. 15 is shown in FIG. 16, and a perspective view is shown in FIG. 17. The acceleration sensor 100 has elastic support arms 130 each of a beam structure, constituted by a thin portion of a silicon single crystal substrate. A mass portion 120 in a center, which is constituted by a thick portion of a silicon single crystal substrate, and a frame 110 in a periphery thereof are connected by the elastic support arms 130. A plurality of strain gauges 140 are formed in each axial direction on the elastic support arms 130.

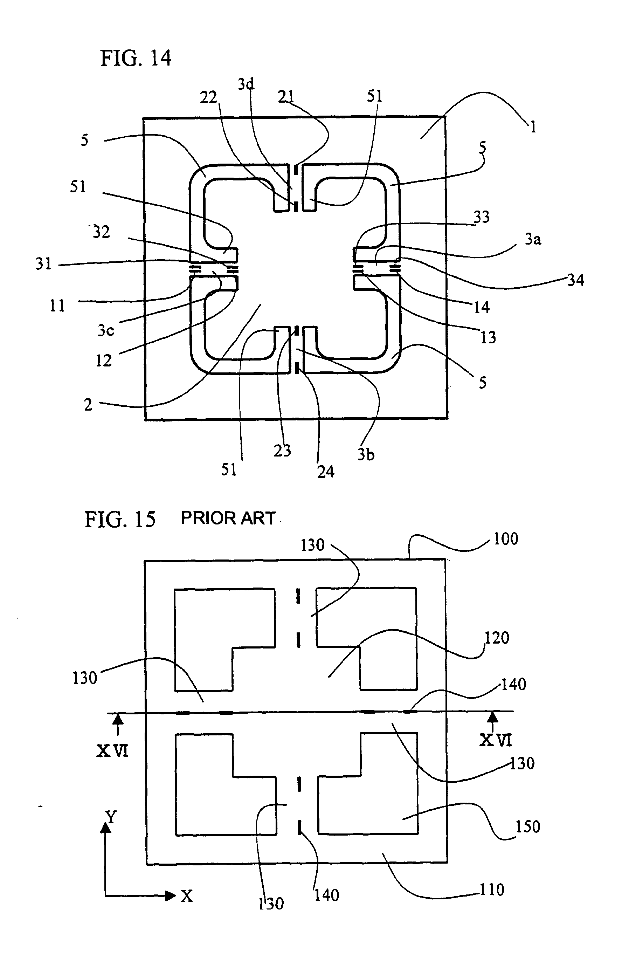

An entire structure will be explained, referring to FIG. 15, FIG. 16 and FIG. 17. The sensor 100 has the mass portion 120 constituted by the thick portion of the silicon single crystal substrate, a frame 110 placed to surround the mass portion 120, and two pairs of elastic support arms 130 in a beam form, which are perpendicular to each other and each constituted by the thin portion of the silicon single crystal substrate to connect the mass portion 120 and the frame 110. When the acceleration works, the mass portion moves in the frame to deform the elastic support arms, and thus the deformation is detected by the strain gauges provided on the elastic support arms to obtain the acceleration that works. The acceleration in an X-axis direction in FIG. 15 is measured by the four strain gauges 140 provided on the elastic support arms extending in the X-axis direction, and the acceleration in a Y-axis direction is measured by the four strain gauges 140 provided on the elastic support arms extending in the Y-axis direction. The acceleration in a Z-axis direction is measured by means of all the strain gauges 140. By making four L-shaped through-holes 150 in the silicon single crystal substrate having the size of the frame 110, the mass portion 120 in the center, the frame 110 in the periphery and the support arms 130 bridging them are formed, and by making the support arm portions thin, the acceleration sensor is constructed to be deformable and highly sensitive.

In the above-described acceleration sensor, to enhance sensitivity, it is effective to increase the volume of the mass portion 120 to increase the mass, or to increase the length of the elastic support arms 130, and as is generally well-known, the sensitivity increases substantially in proportion to the mass of the mass portion and the length of the support arms. That is, the volume of the mass portion 120 is increased, or the length of the elastic support arms 130 are increased, whereby the elastic support arm 130 becomes more deformable and the stress can be effectively transmitted to the strain gauges, thus enhancing sensitivity. However, increasing the mass portion 120 and increasing the length of the elastic support arms 130 are mutually contradictory, and both of them are not mutually compatible especially under the condition that the chip size is kept constant, or when reduction in size is planned. That is, if the mass portion 120 is made larger, the length of the elastic support arms 130 becomes smaller, and a great deal of improvement in sensitivity cannot be improved. Thus, glass pieces and the like are bonded on the back surface of the mass portion 120 in assembly process to increase the volume (that is, weight) of the mass portion 120, whereby the sensitivity is enhanced. The length of the elastic support arms 130 cannot be made large, but the chip is made larger in the thickness direction (the thickness direction of the silicon single crystal substrate), whereby the mass of the mass portion 120 is increased to enhance the sensitivity. Accordingly, it is conventionally impossible to realize a compact and thin acceleration sensor with high sensitivity.

### SUMMARY OF THE INVENTION

The present invention is made in view of the above-described circumstances, and its object is to solve the above-described problem and provide a compact and thin acceleration sensor capable of enhancing sensitivity.

In order to solve the above-described problem, the present invention adopts an acceleration sensor as follows. That is, the acceleration sensor of the present invention has a mass portion provided in a center; a thick frame surrounding the mass portion with a predetermined distance from the mass portion; a plurality of elastic support arms bridging a top surface of the mass portion and the thick frame; and/or strain gauges disposed on the elastic support arms. Further a plurality of recessed portions, which are recessed toward a center of the mass portion from a perimeter thereof, can be formed in the mass portion. Each of the elastic support arms can be attached to the top surface of the mass portion at a bottom of each of the recessed portions, and sides of the elastic support arms can be spaced from sides of the recessed portions.

In the aforementioned acceleration sensor, it is preferable that the acceleration sensor has four elastic support arms, and two of the four elastic support arms of them are orthogonal to the other two of the elastic support arms. It is also preferable that the respective two of the elastic support arms of the four elastic support arms are linearly aligned. It is preferable that the strain gauges for detecting acceleration in a longitudinal direction of the elastic support arms and the strain gauges for detecting acceleration in a direction of a top surface are provided on the two of the elastic support arms that are linearly aligned.

It is preferable that the acceleration sensor of the present invention is made of an SOI wafer, and the plurality of elastic support arms are constituted by a SiO₂ layer and a silicon layer.

In the acceleration sensor of the present invention, when acceleration works on the acceleration sensor, the mass portion is displaced in proportion to the magnitude of the acceleration in the direction of the acceleration. The elastic support arm, which is provided at an outer circumference of the mass portion to extend outward, is bent in a specified direction corresponding to the displacement of the mass portion. At the same time, a plurality of strain gauges provided at the elastic support arm are also distorted. Accordingly, the resistance value of the strain gauges are changed by this distortion. If a detection circuit constituted by a full bridge circuit is constructed with the four strain gauges provided in the respective axis directions, the voltage output corresponding to the amount of the distortion exerted can be obtained.

In the acceleration sensor of the present invention, in the mass portion, two pairs of notches in the substantially rectangular parallelepiped shape, namely, the recessed portions, the width of which is larger than the width of the elastic support arm, are provided to be recessed toward the center from the perimeter of the mass portion correspondingly to two of the X and Y axis directions. The mass portion is connected to the two pairs of elastic support arms on the top surface side of the notches. The volume of the mass portion and the length of the elastic support arm can be independently designed in the range of the necessary and sufficient condition in the performance of the sensor. That is, two design parameters, that are to increase the volume of the mass portion, and increase the length of the elastic support arms, can be freely determined, and therefore high sensitivity can be realized in the small and thin element structure.

### BRIEF DESCRIPTION OF THE DRAWINGS

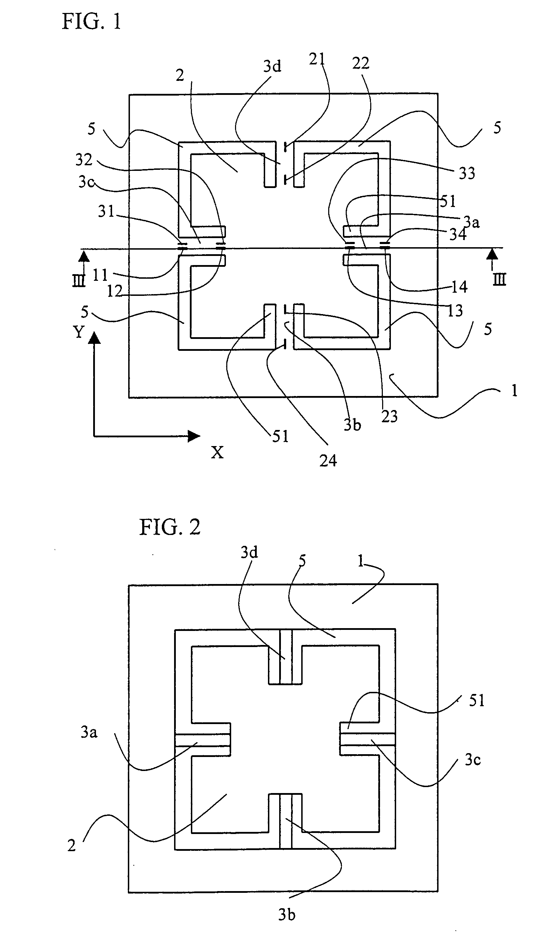

FIG. 1 is a plan view showing an acceleration sensor of the present invention;

FIG. 2 is a bottom view of the acceleration sensor in FIG. 1;

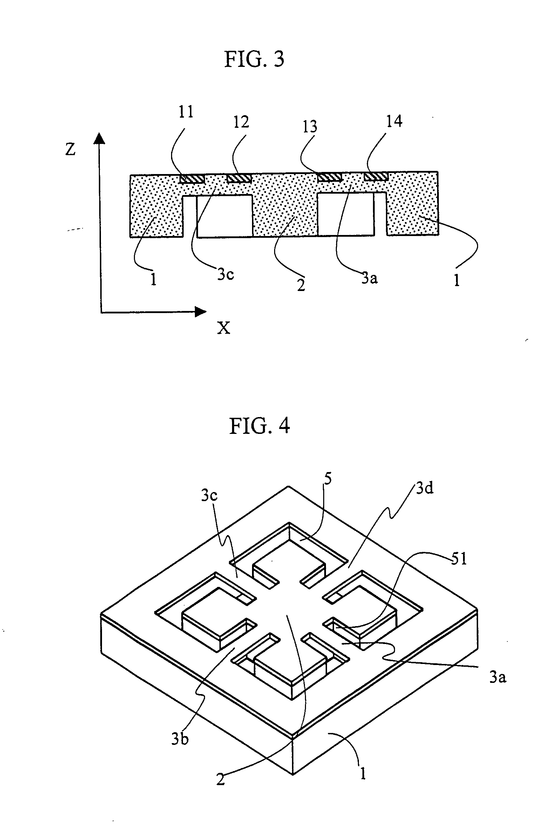

FIG. 3 is a sectional view of the acceleration sensor in FIG. 1 taken along the III-III line in FIG. 1;

FIG. 4 is a perspective view of the acceleration sensor in FIG. 1;

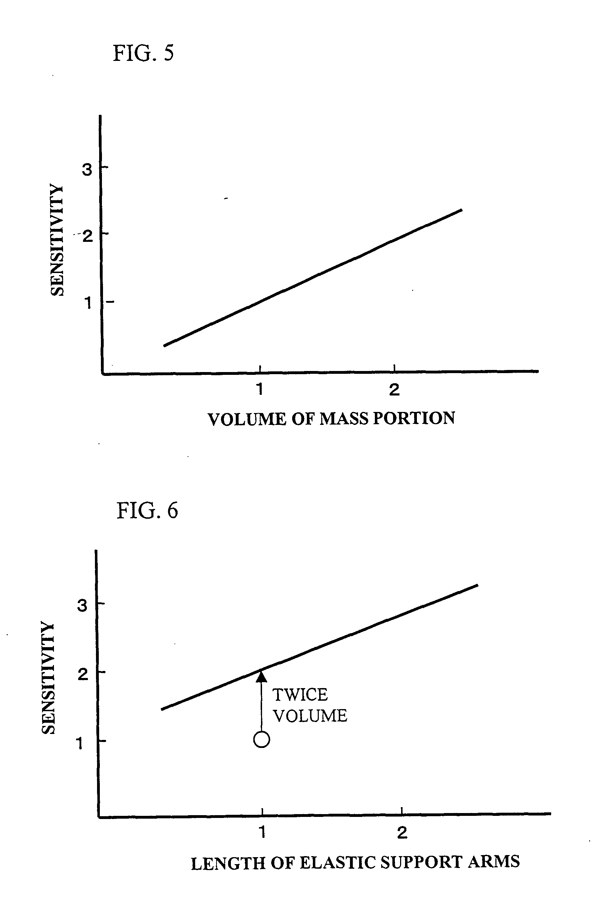

FIG. 5 is a graph showing a relationship between sensitivity and a volume of a mass portion of the acceleration sensor of the present invention;

FIG. 6 is a graph showing a relationship between sensitivity and length of elastic support arms of the acceleration sensor of the present invention;

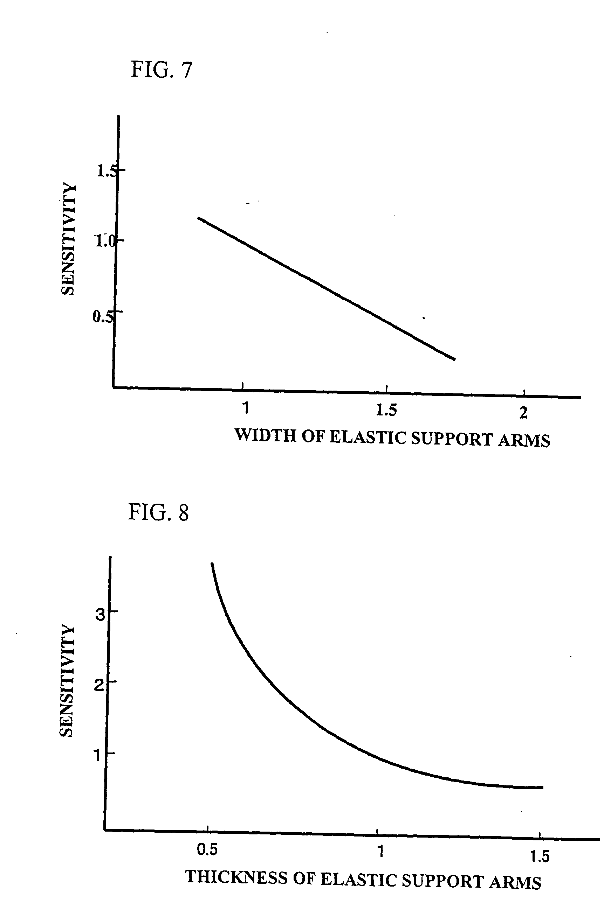

FIG. 7 is a graph showing relationship between sensitivity and width of elastic support arms of the acceleration sensor of the present invention;

FIG. 8 is a graph showing relationship between sensitivity and thickness of elastic support arms of the acceleration sensor of the present invention;

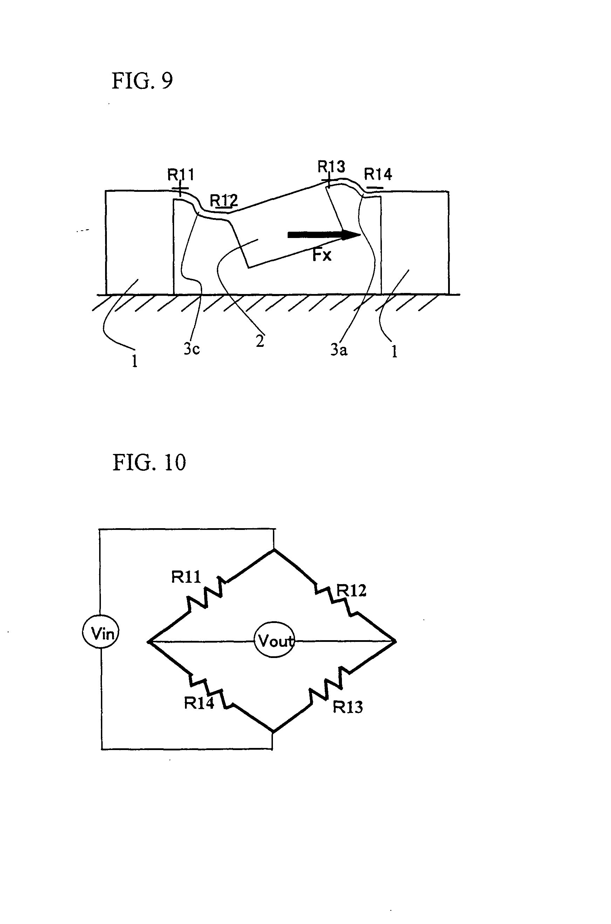

FIG. 9 is a schematic view explaining deformation of the acceleration sensor when acceleration works in an X-axis (Y-axis) direction;

FIG. 10 shows an example of a bridge circuit for measuring acceleration in the X-axis (Y-axis) direction;

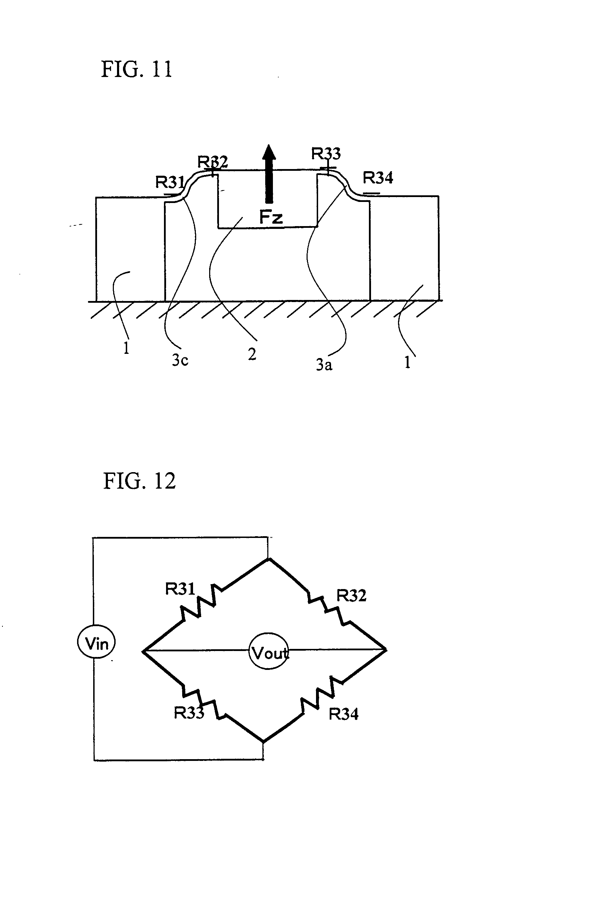

FIG. 11 is a schematic view explaining deformation of the acceleration sensor when acceleration works in a Z-axis direction;

FIG. 12 shows an example of a bridge circuit for measuring acceleration in the Z-axis direction;

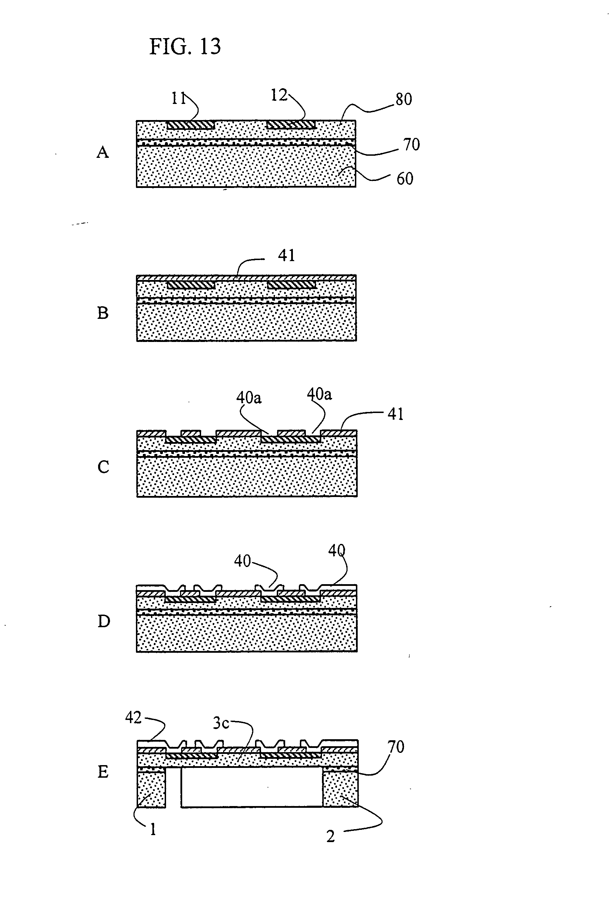

FIG. 13 shows a production process of the acceleration sensor of the embodiment of the present invention in A to E;

FIG. 14 is a plan view showing an acceleration sensor of the present invention;

FIG. 15 is a plan view showing an acceleration sensor disclosed in a Japanese Laid-Open Patent;

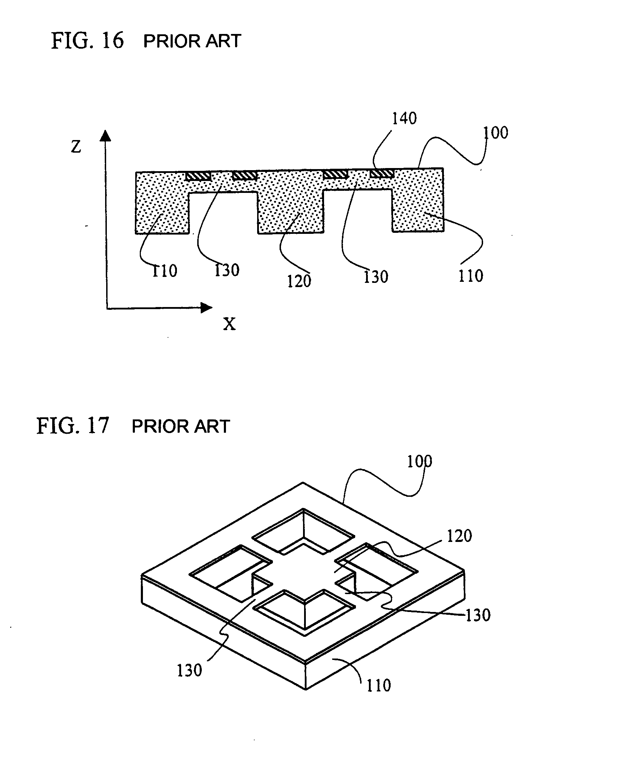

FIG. 16 is a sectional view of the acceleration sensor in FIG. 15 taken along the XVI-XVI line in FIG. 15; and

FIG. 17 is a perspective view of the acceleration sensor in FIG. 15.

First the present invention will be explained with use of FIG. 1, FIG. 2 and FIG. 3. FIG. 1 is a plan view of a semiconductor acceleration sensor of the invention, FIG. 2 is a plan view of the acceleration sensor according to the embodiment of the present invention shown in FIG. 1, which is seen from an underside, and FIG. 3 is a sectional view taken along the III-III line (X-axis) in FIG. 1.

The acceleration sensor in the present invention uses a silicon single crystal substrate with an SOI layer being formed via a SiO₂ insulation layer, namely, an SOI wafer, in order to make it possible to control the thickness of elastic support arms with high precision. The SOI is an abbreviation of Silicon On Insulator. In this example, a wafer formed by thinly forming the SiO₂ insulation layer being an etching stopper (about 1 µm) on a Si wafer with thickness of about 550 µm, on which an N-type silicon single crystal layer with thickness of about 10 µm is formed, is used as a substrate. The acceleration sensor of this embodiment is constituted by a mass portion 2 in a center, which is constituted by a thick portion of the silicon single crystal substrate; a square-shaped frame 1 placed around the mass portion 2 to surround it; two pairs of beam-shaped elastic support arms 3a, 3b, 3c and 3d that are constituted by thin portions of the silicon single crystal substrate to connect the mass portion 2 and the frame 1, strain gauges (in the following explanation, "piezoresistors" as an example of the strain gauge is used, and therefore they are called "piezoresistors") 11, 12, ..., 33, and 34, four of which are for each axis, and which are placed on the elastic support arms correspondingly to two detection axes (X and Y axes) perpendicular to each other and the detection axis (Z axis) orthogonal to the top surface of the acceleration sensor. Namely, the two piezoresistors 13 and 14 and the two piezoresistors 11 and 12 are respectively provided on the elastic support arms 3a and 3c, which extend in the X-axis direction to detect the acceleration in the X-axis direction. The two piezoresistors 21 and 22 and the two piezoresistors 23 and 24 are respectively provided on the elastic support arms 3d and 3b which extend in the Y-axis direction to detect the acceleration in the Y-axis direction. The two piezoresistors 33 and 34 and the two piezoresistors 31 and 32 are respectively provided on the elastic support arms 3a and 3c which extend in the X-axis direction to detect the acceleration in the Z-axis direction. In this example, the acceleration in the Z-axis direction is detected by the piezoresistors provided on the elastic support arms 3a and 3c, but the elements for detecting the acceleration in the Z-axis direction may be provided on the elastic support arms 3d and 3b. Four of the piezoresistors for detecting the acceleration in each axis direction construct a full bridge detection circuit.

In the mass portion 2, a plurality of recessed portions 51, namely, notch portions that are recessed toward the center from the perimeter are formed. Each of the recessed portions 51 is formed from the center of each side of the square-shaped mass portion 2 toward the center of the mass portion. The recessed portion is in a rectangular parallelepiped shape here, and one end of the elastic support arm is attached to the top surface of the mass portion at the bottom of the recessed portion, while the other end of the elastic support arm is attached to the top surface of the thick frame, and the mass portion and the thick frame are bridged with the elastic support arm. It is necessary that the sides of the elastic support arm provided at each of the recessed portions are spaced from the sides of the recessed portion.

To make the sensor structure more understandable, a schematic perspective view is shown in FIG. 4. The same components as in FIGS. 1 to 3 are given the same reference numerals and symbols in FIG. 4. As obvious from FIG. 4, by adopting the structure of the present invention, the volume of the mass portion 2 and the length of the elastic support arms 3a, 3b, 3c and 3d can be independently controlled. Namely, the elastic support arms 3a, 3b, 3c and 3d are made thin and as long as possible, and the mass portion 2 is made as large as possible, whereby the detection sensitivity of the sensor can be improved.

Here, the volume of the mass portion and the length, width and thickness of the elastic support arm, which have an influence on the sensitivity of the acceleration sensor that is the subject of the present invention, will be studied. As the relationship between the sensitivity of the acceleration sensor and the volume (mass) of the mass portion is shown in a graph in FIG. 5, the sensitivity is proportional to the volume (mass) of the mass portion, and if the volume becomes twice, the sensitivity becomes twice. The relationship between the sensitivity of the acceleration sensor and the length of the elastic support arm is shown in FIG. 6. The sensitivity is proportional to the length of the elastic support arm. FIG. 5 and FIG. 6 show the comparison with the other conditions presumed to be the same. In the present invention, the notches or the recessed portions are provided at the mass portion to make the elastic support arms longer, while the volume of the mass portion can be made larger. For this purpose, according to the acceleration sensor of this invention, when the chip size is made constant, even when the length of the elastic support arm is fixed in the present state, the volume of the mass portion 2 can be easily made twice or more without increasing the thickness of the chip, and the sensitivity can be improved in proportion to this. Further, it is easily made possible to make the notch portion larger and make the length of the elastic support arm to be 1.5 times as long as the present length or more, and a decrease in the volume of the mass portion 2 is very small in this situation. The sensitivity increases almost in proportion to the length of the elastic portion. By optimizing the depth of the notch of the mass portion, it is possible to make the chip size smaller without impairing the sensitivity.

For reference, the relationship between the sensitivity and the width of the elastic support arm, and the relationship between the sensitivity and the thickness of the elastic support arm are shown respectively in FIG. 7 and FIG. 8. It is understood that the smaller width and thickness of the elastic support arm are suitable to enhance sensitivity.

The function of the piezoresistors provided at the elastic support arms will be explained here. The elastic support arms 3c and 3a extending in the X-axis direction are provided with the piezoresistors 11 and 12, and 13 and 14 for measuring the acceleration in the X-axis direction. The elastic support arms 3d and 3b extending in the Y-axis direction are provided with the piezoresistors 21 and 22, and 23 and 24 for measuring the acceleration in the Y-axis direction. The elastic support arms 3c and 3a extending in the X-axis direction are provided with the piezoresistors 31 and 32, and 33 and 34 for measuring the acceleration in the Z-axis direction.

When the acceleration in the X-axis direction is exerted on the mass portion 2, a force Fx works on the center of gravity of the mass portion 2, and therefore as shown in FIG. 9, the left side of the top surface of the mass portion 2 moves downward and the right side of the top surface thereof moves upward. As a result, the piezoresistor 11 on the elastic support arm 3c extends, and the piezoresistor 12 contracts. The piezoresistor 13 on the elastic support arm 3a extends, and the piezoresistor 14 contracts. Since the piezoresistors extend and contract like this, the resistances R11, R12, R13 and R14 are changed. When the resistances of the piezoresistors are combined to be a full bridge circuit and a constant voltage Vin is applied thereto as shown in FIG. 10, the change in the resistances of the piezoresistors can be measured according to an output Vout. As for the acceleration in the Y-axis direction, the elastic support arm extending in the Y-axis direction may be considered in the same manner as in the X-axis direction.

When the acceleration in the Z-direction is exerted on the mass portion 2, a force Fz works, and the left and right sides of the top surface of the mass portion 2 move upward as shown in FIG. 11. As a result, the piezoresistor 31 on the elastic support arm 3c contracts, and the piezoresistor 32 extends. In the same manner, the piezoresistor 33 on the elastic support arm 3a extends and the piezoresistor 34 contracts. When the resistances R11, R12, R13 and R 14 of the piezoresistors are combined to be a full bridge circuit and a constant voltage Vin is applied thereto as shown in FIG. 12, the change in the resistances of the piezoresistors can be measured according to the output Vout. It is suitable to change the wire connection of the resistances in the bridge circuit for detecting the acceleration in the Z-axis direction from that in the bridge circuit for detecting the acceleration in the X-axis direction, and therefore other piezoresistors are used.

A production method of this embodiment will be explained below. FIG. 13 shows part (left half) of a section in the X-axis direction (III-III section) in FIG. 1 to explain a main process. As described above, an SOI wafer is a Si single crystal substrate constructed with a Si base substrate 60, an SOI layer 80 on the top surface, which is a Si active layer, and a SiO₂ layer 70, which is between the Si base substrate 60 and the SOI layer 80, and is used as an etching stopper, as denoted by reference numerals in FIG. 13. As for the thickness thereof, the base substrate 60 has thickness of 500 µm to 625 µm, SiO₂ layer has thickness of 1 µm and the SOI layer has thickness of about 10 µm.

The first step of the production process is to make a pattern of a predetermined form with a photoresist or thermally oxidized SiO₂ film or the like on the surface of the SOI layer 80 and to make piezoresistors 11 and 12 with boron being diffused by an impurity diffusion process such as ion implantation (FIG. 13A). As surface impurity density, about 2 × 10¹⁸ atoms/cm³ is adopted, from the viewpoint of both the temperature characteristics and sensitivity.

Next, to protect the piezoresistors 11 and 12, a protection film 41 is produced (FIG. 13B). As the protection film 41, a multilayer film of SiO₂ and PSG (Phosphorous silicated glass) that are generally used in a semiconductor technology are used to have a gettering effect of movable ion. Instead of the two-layer film of SiO₂ and PSG, a two-layer film of SiO₂ and SiN may be used. It is preferable that the thickness of the protection film 41 is made as thin as possible to decrease stress in terms of high sensitivity, and therefore it is made 0.3 µm to 0.5 µm.

Next, through-holes 40a for connecting electrodes are formed in the protection film 41 on both ends of the piezoresistors 11 and 12 by a wet etching with hydrofluoric acid as a predominant component (FIG. 13C).

Next, to make electrode wiring, a film of aluminum alloy (aluminum, copper, silicon and the like are main ingredients) is formed by spattering. The thickness is 0.3 µm to 0.5 µm. Lead electrodes 40 are formed by photo etching (FIG. 13D).

Next, though not shown, the SOI layer 80 is etched by a dry etching method or the like to form a through-hole pattern 5 to the thin portion shown in FIG. 1.

Next, on the base substrate 60 on the back surface a photoresist mask is formed in the shapes of the mass portion 2 and the frame 1 with the positions of the piezoresistors 11 and 12 on the surface, the through-hole pattern 5 to the SOI layer 80 and the like are aligned with use of a double-side aligner device, the base substrate 60 is etched by the dry etching method, and the SiO₂ layer 70 as the etching stopper is removed by wet etching (FIG. 13E). As an etching solution, buffered hydrofluoric acid is used. The shape of the photoresist mask of this process is made a shape provided with rectangular notches at the positions at which the elastic support arms 3a, 3b, 3c and 3d are connected, at four sides of the square mass portion. The elastic support arms 3a, 3b, 3c and 3d are formed in this dry etching process, and in some cases, it is preferable to leave the SiO₂ layer 70 as the etching stopper without removing it in order to keep balance of the entire stress, and a method of leaving part of the SiO₂ layer 70 as the etching stopper on the back side of the elastic support arms may be suitable.

Thereafter, a number of acceleration sensor elements formed on the wafer are cut into sensor chips one by one with use of a dicer or the like, and via the assembly process such as packaging and the like, the semiconductor acceleration sensor is completed.

An acceleration sensor of the present invention will be shown in FIG. 14. FIG. 14 is a plan view of a front side of the sensor, and the same components as in FIG. 1 are given the same reference numerals and symbols to be understandable. In this embodiment, in the mass portion 2, corners of portions extended in four directions as a four-leaf clover are made curved surfaces, and four corner portions in the frame 1 are made curved surfaces at the same time. This has the effect of improving uniformity of etching speed by decreasing a difference of the dimension of the pattern width and improving the flow of the etching gas on the occasion of dry etching of the mass portion 2 in the production process described with reference to FIG. 13, as the effect peculiar to this invention, as well as the effect of making it possible to enhance sensitivity with the sensor being made compact and thin as already explained. The mechanical strength of the frame portion can also be increased.

As described thus far, the through-hole pattern 5 formed in the SOI layer 80 and the pattern which is removed by penetration etching when the mass portion 2 is formed by etching the base substrate 60 from the back side of the wafer are in the same shape, but they do not necessarily need to correspond to each other, and it may be suitable if only the mass portion 2 and the elastic support arms 3a, 3b, 3c and 3d, and the frame 1 are separated. The through-hole pattern 5 to the SOI layer 80 and the pattern shape of the mass portion 2 themselves can be variously considered other than already described. Namely, as the shapes of the mass portion 2 and the frame 1, various shapes can be considered, and they are not limited to the shapes described.

## Claims

1. An acceleration sensor, comprising:
a mass portion (2) existing in a center;
a thick frame (1) surrounding the mass portion (2) with a predetermined distance from the mass portion (2);
a plurality of elastic support arms (3) bridging a top surface of the mass portion (2) and the thick frame (1); and
strain gauges disposed on the elastic support arms (3),
wherein a plurality of recessed portions (51), which are recessed toward a center of the mass portion (2) from a perimeter thereof, are formed in the mass portion (2), each of the elastic support arms (3) is attached to the top surface of the mass portion (2) at a bottom of each of the recessed portions (51), and sides of the elastic support arms (3) are spaced from sides of the recessed portions (51).

2. An acceleration sensor according to claim 1, wherein the acceleration sensor has the four elastic support arms (3), and two of the elastic support arms (3) of them are orthogonal to the other two of the elastic support arms (3).

3. An acceleration sensor according to claim 2, wherein the respective two of the four elastic support arms (3) are linearly aligned.

4. An acceleration sensor according to claim 3, wherein the strain gauges for detecting acceleration in a longitudinal direction of the elastic support arms (3) and the strain gauges for detecting acceleration in a direction of a top surface are disposed on the two of the elastic support arms (3) which are linearly aligned.

5. An acceleration sensor according to claim 3, wherein the acceleration sensor is made of an SOI wafer, and the plurality of elastic support arms (3) are constituted by a SiO₂ layer (70) and a silicon layer.

6. An acceleration sensor according to claim 4, wherein the acceleration sensor is made of an SOI wafer, and the plurality of elastic support arms (3) are constituted by a SiO₂ layer (70) and a silicon layer.
